# EUROPÄISCHE PATENTANMELDUNG

(11) **EP 2 173 028 A2**
(43) Veröffentlichungstag der Anmeldung: **07.04.2010**
(21) Anmeldenummer: 09171365.1
(22) Anmeldetag: 25.09.2009
(51) Int. Cl.: H03B 5/12, H03C 3/08, H03C 3/20

(54) **Verfahren zur Regelung einer Grundfrequenz eines spannungsgesteuerten Oszillators als eine Trägerfrequenz eines frequenzmodulierten Signals**

(30) Priorität: 01.10.2008 DE 102008042519
(71) Anmelder: Robert Bosch GmbH, 70442 Stuttgart (DE)
(72) Erfinder: Nehmelmann, Holger, 71229 Leonberg (DE); Katchan, Igor, 76149 Karlsruhe (DE); Lindner, Markus, 70180 Stuttgart (DE); Albrecht, Andrej, 70567 Stuttgart (DE)

(57) **Zusammenfassung**

Verfahren zur Regelung einer Grundfrequenz eines spannungsgesteuerten Oszillators als eine Trägerfrequenz eines frequenzmodulierten Signals,
wobei zu einer Erzeugung des frequenzmodulierten Signals die Grundfrequenz des spannungsgesteuerten Oszillators als die Trägerfrequenz in Abhängigkeit eines Nutzsignals moduliert wird,
wobei das Nutzsignal den spannungsgesteuerten Oszillator über einen Schwingkreis derart ansteuert, dass aufgrund einer Variation einer Kapazität einer ersten Kapazitätsdiode des Schwingkreises durch das Nutzsignal die Grundfrequenz mit dem Nutzsignal moduliert wird,
**dadurch gekennzeichnet, dass** die Grundfrequenz dadurch geregelt wird, dass die erste und eine zweite Kapazitätsdiode in dem Schwingkreis durch ein Spannungssignal einer gemeinsamen Spannungsquelle angesteuert werden.

## Beschreibung

### Stand der Technik

Die Erfindung geht aus von einem Verfahren und einer Vorrichtung nach Gattung der unabhängigen Ansprüche.

Zur Übertragung von Nutzsignalen, vorzugsweise Audiosignalen, ist es bekannt, eine Frequenzmodulation einer Trägerfrequenz durch das Nutzsignal zur Erzeugung eines frequenzmodulierten Signals durchzuführen. Das frequenzmodulierte Signal wird dann von einem Sender zu einem Empfänger übertragen, wobei der Empfänger das frequenzmodulierte Signal wiederum demoduliert und hieraus das Nutzsignal gewinnt.

Das Verfahren einer Frequenzmodulation und einer Demodulation wird beispielsweise zur Audioübertragung von einem Sender zu einem Kopfhörer verwendet. Aus Kostengründen kommen hierbei mitunter infrarote Audioübertragungsverfahren zum Einsatz. Die hierbei benutzte Trägerfrequenz liegt im infraroten Bereich. Vorzugsweise werden hierbei Audiosignale eines CD-Players, eines MP3-Players oder anderer Audio- oder auch Videoquellen im Fahrzeug von einem Sender zu einem Empfänger übertragen.

Damit eine Audioübertragung nach dem Prinzip der Frequenzmodulation ordnungsgemäß funktioniert, muss die Trägerfrequenz des Senders mit der Trägerfrequenz des Empfängers übereinstimmen.

Aus der US 5564100 A ist eine Vorrichtung zur Ansteuerung eines spannungsgesteuerten Oszillators unter Verwendung eines einstellbaren Kondensators bekannt.

### Offenbarung der Erfindung

### Vorteile der Erfindung

Das erfindungsgemäße Verfahren mit den Merkmalen des unabhängigen Anspruchs hat gegenüber dem Stand der Technik den Vorteil, dass eine Grundfrequenz eines spannungsgesteuerten Oszillators als eine Trägerfrequenz eines frequenzmodulierten Signals dadurch geregelt wird, dass in einem Schwingkreis zur Ansteuerung des Oszillators eine erste und eine zweite Kapazitätsdiode durch eine gemeinsame Spannungsquelle angesteuert werden. Dieses hat den Vorteil, dass aufgrund einer gemeinsamen Ansteuerung der beiden Dioden in dem Schwingkreis durch eine gemeinsame Spannungsquelle eine Abhängigkeit einer relativen Kapazitätsänderung der ersten Diode von einem Arbeitspunkt der ersten Diode durch die zweite Diode entgegengewirkt wird. Hierdurch wird erreicht, dass eine relative Kapazitätsänderung durch das Nutzsignal näherungsweise konstant ist, sodass der Einfluss der Amplitude des Nutzsignals unabhängig von der angesteuerten Grundfrequenz ist.

Durch die in den abhängigen Ansprüchen aufgeführten Maßnahmen sind vorteilhafte Weiterbildungen und Verbesserungen des im unabhängigen Anspruch angegebenen Verfahrens möglich.

Gemäß einer weiteren Ausführungsform der Erfindung wird als Spannungssignal der gemeinsamen Spannungsquelle ein durch eine Tiefpassschaltung gefiltertes Puls-Weiten-Modulationssignal verwendet. Dieses hat den Vorteil, dass zur Erzeugung des Spannungssignals aufgrund der Glättungseigenschaften der Tiefpassschaltung auf ein Puls-Weiten-Modulationssignal zurückgegriffen werden kann, welches aufgrund von weiteren Bauteilen, welche im Kfz-Bereich üblich sind, insbesondere in Anzeigesystemen von Kfz-Systemen, bereits bereitsteht. Hierdurch erübrigt sich eine gesonderte Spannungsquelle, wodurch ein zusätzlicher Schaltungsaufwand vermieden wird.

Gemäß einer weiteren Ausführungsform der Erfindung wird als Spannungssignal ein durch eine Digital-Analog-Wandlung gewonnenes Signal verwendet. Dieses ist vorteilhaft, da durch eine Digital-Analog-Wandlung ein Spannungssignal in besonders präzisier Weise bereitgestellt werden kann.

Gemäß einer weiteren Ausführungsform der Erfindung werden als erste und zweite Kapazitätsdiode unterschiedliche Dioden verwendet. Dieses hat den Vorteil, dass somit der Schwingkreis und dadurch die Ansteuerung des spannungsgesteuerten Oszillators an unterschiedliche Anforderungen angepasst werden kann.

Gemäß einer weiteren Ausführungsform der Erfindung erfolgt die Ansteuerung der Kapazitätsdioden durch das Spannungssignal über unterschiedliche Widerstände. Dieses birgt den Vorteil, dass hierdurch eine Adaption des Schwingkreises bzw. der Ansteuerung des spannungsgesteuerten Oszillators in Abhängigkeit einer zu erzielenden Wirkung angepasst werden kann.

Gemäß einer weiteren Ausführungsform der Erfindung wird aus einem Vergleich des frequenzmodulierten Signals mit einem Referenzsignal eine Vergleichsgröße abgeleitet, sodass in Abhängigkeit der Vergleichsgröße das Spannungssignal der gemeinsamen Spannungsquelle zur Regelung der Grundfrequenz verändert wird. Dieses birgt den Vorteil, dass mittels der Vergleichsgröße ein Abweichen des frequenzmodulierten Signals von einem Referenzsignal eine unerwünschte Veränderung des frequenzmodulierten Signals, beispielsweise durch Temperatureinwirkungen auf den Schwingkreis, detektiert werden kann. Somit kann dieser Änderung durch eine Veränderung des Spannungssignals der gemeinsamen Spannungsquelle zur Regelung der Grundfrequenz entgegengewirkt werden.

Gemäß eines nebengeordneten Anspruchs wird eine Vorrichtung zur Regelung einer Grundfrequenz eines spannungsgesteuerten Oszillators als eine Trägerfrequenz eines frequenzmodulierten Signals beansprucht. Die Vorrichtung weist einen Schwingkreis mit einer ersten Kapazitätsdiode zu einer Ansteuerung des Oszillators auf. Hierbei weist der Schwingkreis einen Nutzsignaleinspeisungspunkt zur Einspeisung eines Nutzsignals auf. Durch Einspeisung des Nutzsignals an dem Nutzsignaleinspeisungspunkt wird eine an der Kapazitätsdiode anliegende Spannung und somit eine Kapazität der Kapazitätsdiode derart variiert, dass das Grundfrequenzsignal mit dem Nutzsignal moduliert wird. Die Vorrichtung ist **dadurch gekennzeichnet, dass** durch eine Ansteuerung der ersten und einer zweiten Kapazitätsdiode des Schwingkreises durch ein Spannungssignal einer gemeinsamen Spannungsquelle eine Regelung der Grundfrequenz vorgenommen wird. Die Vorrichtung birgt den Vorteil, dass dem Effekt einer nichtlinearen Kennlinie der ersten Kapazitätsdiode und somit einer nicht konstanten relativen Kapazitätsänderung der Kapazitätsdiode durch eine derartige Ansteuerung der ersten und der zweiten Kapazitätsdiode entgegen gewirkt wird.

Gemäß einer weiteren Ausführungsform weist die Vorrichtung eine Referenzeinheit zur Bereitstellung eines Referenzsignals auf. Ferner weist die Vorrichtung eine Vergleichseinheit zur Ableitung einer Vergleichgröße aus dem frequenzmodulierten Signal und dem Referenzsignal auf. Die Vergleichseinheit steuert die gemeinsame Spannungsquelle in Abhängigkeit der Vergleichsgröße derart an, dass durch eine Änderung des Spannungssignals der gemeinsamen Spannungsquelle die Grundfrequenz geregelt wird. Die Vorrichtung birgt den Vorteil, dass die gemeinsame Spannungsquelle durch eine derartige Ansteuerung im Falle eines Abweichens des frequenzmodulierten Signals von dem Referenzsignal in ungewünschter Weise einer solchen Änderung entgegen gewirkt wird.

Gemäß einer weiteren Ausführungsform weist die gemeinsame Spannungsquelle eine Generatoreinheit zur Erzeugung eines Pulsweitenmodulationssignals und eine Tiefpassschaltung auf. Dieses hat den Vorteil, dass das benötigte Spannungssignal der gemeinsamen Spannungsquelle durch einen besonders einfachen Aufbau der Spannungsquelle realisiert werden kann. Hierbei kann auf eine Generatoreinheit zurückgegriffen werden, welche ein Puls-Weiten-Modulationssignal bereitstellt, wie sie im Bereich von Anzeigesystemen von Kraftfahrzeugen häufig aufzufinden sind, sodass eine derartige Generatoreinheit direkt zur Realisierung der gemeinsamen Spannungsquelle verwendet werden kann.

Gemäß einer weiteren Ausführungsform der Erfindung umfasst die gemeinsame Spannungsquelle eine Wandlereinheit zur Wandlung eines Digitalsignals in das Spannungssignal. Dieses birgt den Vorteil, dass durch Wandlung eines Digitalsignals das Spannungssignal in besonders präzisier Weise bereitgestellt werden kann.

### Kurze Beschreibung der Zeichnung

Ausführungsbeispiele der Erfindung sind in den Zeichnungen dargestellt und in der nachfolgenden Beschreibung näher erläutert. Es zeigen
Figur 1 einen Schwingkreis mit einer Kapazitätsdiode zur Ansteuerung eines spannungsgesteuerten Oszillators gemäß des Standes der Technik.
Figur 2 eine Ausführungsform einer erfindungsgemäßen Vorrichtung.
Figur 3 eine Ausführungsform einer gemeinsamen Spannungsquelle.
Figur 4 eine weitere Ausführungsform einer erfindungsgemäßen Vorrichtung.

Das der Erfindung zugrunde liegende Prinzip ist die Veränderung einer Kapazität einer Kapazitätsdiode eines Schwingkreises, welcher einen spannungsgesteuerten Oszillator ansteuert. Durch die Veränderung der Kapazität wird die Resonanzfrequenz des Schwingkreises verändert, sodass sich hierdurch die Grundfrequenz des an den Schwingkreis angeschlossenen und durch den Schwingkreis angesteuerten spannungsgesteuerten Oszillators ändert bzw. regeln lässt.

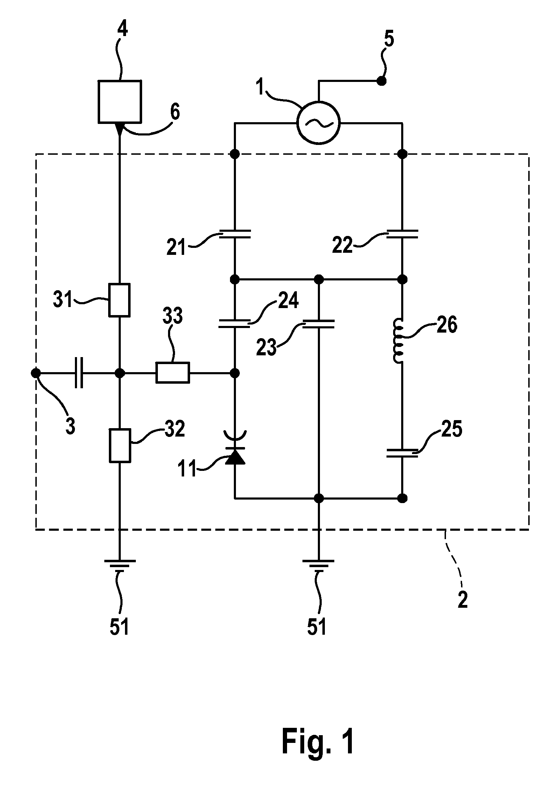

In der Figur 1 ist ein spannungsgesteuerter Oszillator 1 dargestellt, welcher an seinem Ausgang 5 ein Ausgangssignal bereitstellt. Der spannungsgesteuerte Oszillator 1 wird über einen Schwingkreis 2 angesteuert. Der Schwingkreis 2 weist einen Nutzsignaleinspeisungspunkt 3 auf, an welchem ein Nutzsignal in den Schwingkreis eingespeist wird. Liegt an dem Nutzsignaleinspeisungspunkt 3 kein Signal an, so weist das Ausgangssignal am Ausgang 5 des spannungsgesteuerten Oszillators 1 eine Grundfrequenz auf. Liegt ein Nutzsignal an dem Nutzsignaleinspeisungspunkt 3 an, so liegt an dem Ausgang 5 ein frequenzmoduliertes Signal an, wobei die Grundfrequenz des spannungsgesteuerten Oszillators 1 der Trägerfrequenz des frequenzmodulierten Signals entspricht. Der Schwingkreis 2 weist Kondensatoren 21, 22, 23, 24, 25 sowie Spulen 26 auf. Ferner weist der Schwingkreis eine erste Kapazitätsdiode 11 auf. Eine Spannungsquelle 4 weist an ihrem Ausgang 6 ein Spannungssignal auf, welches über ein Netzwerk von Widerständen 31, 32, 33 des Schwingkreises 2 in jenem Bereich des Schwingkreises 2 eingespiesen wird, in welchem sich die erste Kapazitätsdiode befindet. Ferner ist der Schwingkreis 2 mit einem Nullpotenzial 51 verbunden.

Ist kein Nutzsignal an dem Nutzsignaleinspeisungspunkt 3 angelegt, und wird as Spannungssignal 6 der Spannungsquelle 4 unverändert gehalten, so ändert sich auch die an der ersten Kapazitätsdiode anliegende Spannung nicht, sodass der Schwingkreis 2 den spannungsgesteuerten Oszillator derart ansteuert, dass dieser am Ausgang 5 ein Signal aufweist, welches unverändert mit der Grundfrequenz schwingt. Liegt an dem Nutzsignaleinspeisungspunkt 3 das Nutzsignal an, welches vorzugsweise über einen Kondensator 41 in den Schwingkreis eingespiesen wird, so ändert sich die an der ersten Kapazitätsdiode 11 anliegende Spannung in Abhängigkeit des Nutzsignals. Hierbei erfolgt eine Variation der Kapazität der ersten Kapazitätsdiode durch das Nutzsignal, sodass es zu einer Modulation der Grundfrequenz des spannungsgesteuerten Oszillators 1 mit dem Nutzsignal kommt. Somit kann am Ausgang 5 des spannungsgesteuerten Oszillators 1 das frequenzmodulierte Signal abgegriffen werden, welches sich durch Modulation der Grundfrequenz als Trägerfrequenz durch das Nutzsignal ergibt.

Durch eine Veränderung des Spannungssignals 6 durch die Spannungsquelle 4 wird ebenfalls eine Änderung der an der ersten Kapazitätsdiode 11 anliegenden Spannung verursacht, wodurch sich eine Änderung der Grundfrequenz des spannungsgesteuerten Oszillators ergibt. Eine Abstimmung der Grundfrequenz erfolgt gemäß des Standes der Technik entweder durch eine Änderung des Spannungssignals am Ausgang 6 der Spannungsquelle 4, oder durch Kondensatoren 20 bis 25 oder Spulen 26, welche manuell justiert werden können, um die Schwingungseigenschaften des Schwingungskreises 2 und somit die Grundfrequenz des spannungsgesteuerten Oszillators 1 zu verändern.

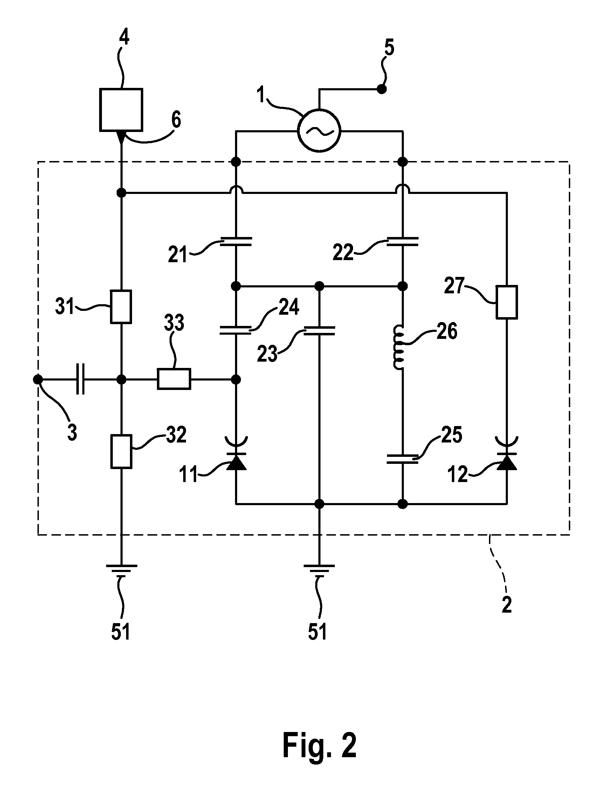

Figur 2 zeigt eine erfindungsgemäße Vorrichtung zur Regelung einer Grundfrequenz eines spannungsgesteuerten Oszillators 1. Hierbei weist Figur 2 sämtliche Bauteile wie Figur 1 auf, wobei auch die Bezugszeichen identisch sind. Ferner weist die Figur 2 weitere Bauteile auf, welche nun im Detail beschrieben werden. Erfindungsgemäß erfolgt eine Ansteuerung der ersten Kapazitätsdiode 11 durch die Spannungsquelle 4 einhergehend mit einer gleichzeitigen Ansteuerung eine weiteren, zweiten Kapazitätsdiode 12 des Schwingkreises 2. Hierbei wird das Ausgangssignal des Ausgangs 6 der Spannungsquelle 4 nicht nur in der zuvor beschriebenen Weise zur Beeinflussung der an der ersten Kapazitätsdiode 11 anliegenden Spannung verwendet, sondern auch dazu, eine an der zweiten Kapazitätsdiode 12 anliegende Spannung zu verändern. Hierbei wird vorzugsweise das Spannungssignal der gemeinsamen Spannungsquelle 4 über einen weiteren Widerstand 27 auf die zweite Kapazitätsdiode 12 des Schwingkreises 2 gegeben. Vorzugsweise befindet sich die zweite Kapazitätsdiode 12 in Parallelschaltung zu der ersten Kapazitätsdiode 11 des Schwingkreises 2. Steuert nun die gemeinsame Spannungsquelle 4 die erste Kapazitätsdiode 11 und die zweite Kapazitätsdiode 12 durch ihr Spannungssignal gemeinsam an, so erfolgt hierdurch eine Regelung der Grundfrequenz des spannungsgesteuerten Oszillators 11.

Die erfindungsgemäße Vorrichtung sowie das erfindungsgemäße Verfahren weisen gegenüber dem Stand der Technik entscheidende Vorteile auf. Wird, wie in Figur 1 gemäß des Standes der Technik dargestellt, eine Veränderung der Spannung an der ersten Kapazitätsdiode 11 durch eine Änderung des Spannungssignals der Spannungsquelle 4 vorgenommen, so ergibt sich hierbei eine Änderung des Arbeitspunktes der ersten Kapazitätsdiode 11. Abhängig von dem Arbeitspunkt der ersten Kapazitätsdiode 11 ist jedoch die durch das Nutzsignal herbeigeführte relative Kapazitätsänderung der Kapazität der ersten Kapazitätsdiode 11. Die relative Kapazität bestimmt die Intensität bzw. die Amplitude der Modulation der Grundfrequenz des spannungsgesteuerten Oszillators 1. Wird also durch die Spannungsquelle 4 eine Änderung der an der ersten Kapazitätsdiode 11 anliegenden Spannung und somit eine Änderung des Arbeitspunktes der ersten Kapazitätsdiode 11 zur Änderung der Grundfrequenz des spannungsgesteuerten Oszillators 1 vorgenommen, so kann es je nach Wahl des Arbeitspunktes bzw. der Grundfrequenz dazu kommen, dass sich das Nutzsignal unterschiedlich stark auf die Modulation der Grundfrequenz bzw. die Trägerfrequenz im Zuge der Frequenzmodulation auswirkt.

Dem Effekt der Arbeitspunktänderung der somit nicht konstanten relativen Kapazitätsänderung durch das Nutzsignal wird erfindungsgemäß durch das Vorsehen der zweiten Kapazitätsdiode 12 entgegengewirkt. Insbesondere durch die gemeinsame Ansteuerung der ersten Kapazitätsdiode 11 und der zweiten Kapazitätsdiode 12 durch die gleiche gemeinsame Spannungsquelle 4 wird es ermöglicht, dass bei Änderung der Grundfrequenz des spannungsgesteuerten Oszillators 1 sich eine unterschiedliche Wahl des Arbeitspunktes der ersten Kapazitätsdiode 11 sowie der zweiten Kapazitätsdiode 12 deutlich weniger auf eine gleichzeitige Änderung der relativen Kapazitätsänderungen der Kapazitätsdioden auswirkt. Hierdurch wird also im Falle einer Änderung der Grundfrequenz des spannungsgesteuerten Oszillators 1 durch eine Ansteuerung mittels der gemeinsamen Spannungsquelle 4 Sorge getragen, dass auch bei unterschiedlichen Grundfrequenzen des spannungsgesteuerten Oszillators 1 eine näherungsweise konstante relative Kapazitätsänderung der Kapazitätsdioden durch das Nutzsignal vorliegt, sodass sich auch eine näherungsweise konstante Auswirkung der Amplitude des Nutzsignals zur Frequenzmodulation der Grundfrequenz ergibt.

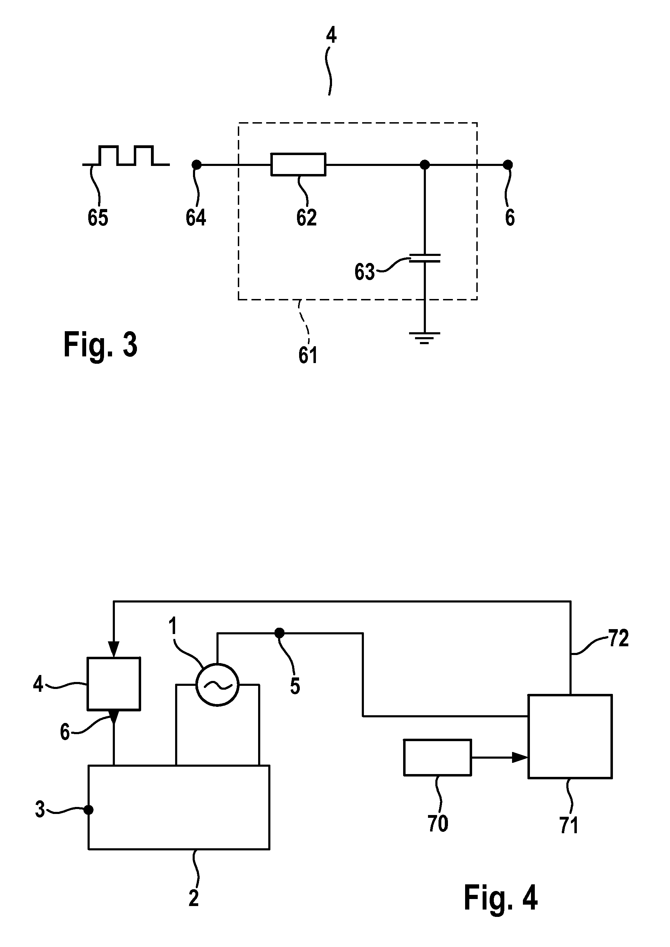

Figur 3 zeigt eine Ausführungsform der gemeinsamen Spannungsquelle 4. Hierbei wird durch eine Generatoreinheit ein Puls-Weiten-Modulationssignal 65 an einem Einspeisungspunkt 64 in eine Tiefpassschaltung 61 eingespeist. Vorzugsweise ist die Tiefpassschaltung ein Tiefpass, welcher aus einem Widerstand 62 sowie einem Kondensator 63 besteht. Hierbei wird durch den Tiefpass 61 eine Glättung des Puls-Weiten-Modulationssignal derart 65 vorgenommen, dass an dem Ausgang 6 der Spannungsquelle 4 näherungsweise eine Gleichspannung anliegt. Durch Änderung der Pulsweite kann vorzugsweise eine Änderung des Spannungssignals an dem Ausgang 6 herbeigeführt werden.

Durch eine Verwendung von unterschiedlichen Kapazitätsdioden als die erste und die zweite Kapazitätsdiode 11, 12 sowie durch eine Verwendung unterschiedlicher Widerstände 31, 32, 27 zur Ansteuerung der ersten Kapazitätsdiode 11 und der zweiten Kapazitätsdiode 12 durch das Spannungssignal der gemeinsamen Spannungsquelle 4 kann die erfindungsgemäße Vorrichtung vorzugsweise an unterschiedliche Applikationen angepasst werden.

Figur 4 zeigt ein weiteres Ausführungsbeispiel einer erfindungsgemäßen Vorrichtung. In der Figur 4 ist der aus der Figur 2 gezeigte Schwingkreis 2 mit seinem Nutzsignaleinspeisungspunkt 3 gezeigt. An den Schwingkreis ist der spannungsgesteuerte Oszillator 1 mit seinem Ausgang 5 angeschlossen. Ferner ist der Schwingkreis an den Ausgang 6 der gemeinsamen Spannungsquelle 4 der ersten und der zweiten Kapazitätsdiode angeschlossen. Eine Differenzeinheit 70 stellt ein Referenzsignal bereit, welches durch eine Vergleichseinheit 71 mit dem frequenzmodulierten Signal des Ausgangs 5 des spannungsgesteuerten Oszillators verglichen wird. Die Vergleichseinheit 71 leitet aus einem Vergleich des Referenzsignals der Referenzeinheit 70 und des frequenzmodulierten Signals eine Vergleichsgröße ab, so dass ein Abweichen der Grundfrequenz bzw. der Trägerfrequenz des frequenzmodulierten Signals von dem Referenzsignal festgestellt werden kann. In Abhängigkeit der Vergleichsgröße steuert die Vergleichseinheit 71 über eine Ansteuerungsleitung 72 die gemeinsame Spannungsquelle 4 derart an, dass durch eine Änderung des Spannungssignals der gemeinsamen Spannungsquelle die Grundfrequenz des spannungsgesteuerten Oszillators und somit die Trägerfrequenz des frequenzmodulierten Signals geregelt wird.

Durch eine in Figur 4 gezeigte Regelung ist es möglich, sogenannten Drifteffekten, welche beispielsweise durch eine Temperaturabhängigkeit von Bauteilen entstehen, während des Betriebes des Oszillators 1 auszugleichen. Derartige Drifteffekte bzw. Temperaturabhängigkeiten kommen im Kraftfahrzeug vor, da ein Kraftfahrzeug mitunter Außentemperaturen von -40°C bis hin zu 85°C ausgesetzt ist. Ferner treten derartige Effekte auch schon deshalb auf, da sich die Temperatur von Vorrichtungen, Geräten oder Bauteilen im Kraftfahrzeug durch längeren Betrieb mitunter stark ändert.

Gemäß einer Ausführungsform handelt es sich bei dem Referenzsignal der Referenzeinheit 70 um ein Signal, welches einen Referenztakt aufweist, beispielsweise in Form eines Referenzsignals, welches eine Schwingung mit einer festen Frequenz aufweist. Ein Vergleich des Referenzsignals mit dem frequenzmodulierten Signal des Ausgangs 5 durch die Vergleichseinheit 71 erfolgt vorzugsweise derart, dass über einen festen Zeitraum die Anzahl der Schwingungsperioden des frequenzmodulierten Signals gezählt wird und mit der Anzahl an Schwingungsperioden des Referenzsignals während des festen Zeitraumes verglichen wird. Hierbei kann das Referenzsignal vorzugsweise unter Verwendung eines Quarzoszillators bereitgestellt werden.

Vorzugsweise lässt sich auch eine feste Anzahl von Schwingungsperioden des Referenzsignals zählen, so dass nach dieser Anzahl Schwingungsperioden die in dem vorgegebenen Zeitraum erfolgten Schwingungsperioden des frequenzmodulierten Signals bestimmt und mit der Anzahl der Schwingungsperioden des Referenzsignals verglichen werden. Eine Ansteuerung der gemeinsamen Spannungsquelle 4 durch die Vergleichseinheit 71 erfolgt vorzugsweise derart, dass in dem Fall, dass als gemeinsame Spannungsquelle ein Pulsweitenmodulationssignal 65 verwendet wird, das Taktverhältnis der Pulsweitenmodulation erhöht oder erniedrigt wird.

Die Vergleichseinheit 71 weist zum Vergleich des frequenzmodulierten Signals mit dem Referenzsignal der Referenzeinheit 70 vorzugsweise jeweilige Zähler für die jeweiligen Signale auf, welche die jeweiligen Schwingungsperioden der jeweiligen Signale innerhalb eines gewissen Zeitraumes bestimmen, so dass in der Vergleichseinheit 71 vorzugsweise durch eine Komparatoreinheit die in dem gewissen Zeitraum erfolgten Schwingungsperioden, welche durch die jeweiligen Zähler bestimmt wurden, verglichen werden. In Abhängigkeit des Vergleiches wird dann durch die Vergleichseinheit 71 die gemeinsame Spannungsquelle 4 angesteuert.

Für Anwendung von mehreren Nutzsignalen mittels unterschiedlicher Trägerfrequenzen, beispielsweise auf den Frequenzen 2,3MHz, 2,8MHz, 3,3MHz, 3,8MHz, 4,3MHz oder 4,8MHz, ist es mitunter notwendig, das Referenzsignal der Referenzeinheit 70 deutlich höher zu wählen als die Trägerfrequenz, beispielsweise 33Mhz. Hierzu wird vorzugsweise das Referenzsignal der Referenzeinheit 71 in der Referenzeinheit 71 mittels einer Phased-Lock-Loop-Schaltung (PLL) unter Verwendung eines Taktsignals eines Quarzoszillators erzeugt. Derartige Phased-Lock-Loop-Schaltungen lassen sich besonders einfach mittels ihrer gewählten Teilerverhältnisse und Frequenzen auf unterschiedliche gewünschte Trägerfrequenzen einstellen.

Ein oben genannter Vergleich eines frequenzmodulierten Signals des Ausgangs 5 eines spannungsgesteuerten Oszillators mit einem Referenzsignal einer Referenzeinheit 70 zur Regelung der Grundfrequenz des spannungsgesteuerten Oszillators 1 als Trägerfrequenz des frequenzmodulierten Signals kann vorzugsweise in einer solchen Betriebssituation erfolgen, in welcher an dem Nutzsignaleinspeisungspunkt 3 des Schwingkreises 2 kein Nutzsignal anliegt. In einem solchen Fall schwingt der spannungsgesteuerte Oszillator mit einer einmal eingestellten Grundfrequenz. Somit kann in einem solchen Betriebsmodus die Grundfrequenz des spannungsgesteuerten Oszillators 1 während jeglicher Zeiträume beobachtet werden, ohne dass es zu einer Veränderung der Grundfrequenz durch das Nutzsignal kommt.

Vorzugsweise erfolgt eine Regelung der Grundfrequenz auch in einem solchen Betriebsmodus, in welchem an dem Nutzsignalpunkt 3 ein Nutzsignal anliegt. Eine Regelung in einem solchen Betriebsmodus hat den Vorteil, dass während des laufenden Betriebes die Grundfrequenz des spannungsgesteuerten Oszillators 1 überprüft und geregelt werden kann. Während also die Vorrichtung zur Übertragung von Signalen mittels einer Frequenzmodulation, vorzugsweise zur Audioübertragung, verwendet wird, ist es möglich, gleichzeitig die Grundfrequenz des spannungsgesteuerten Oszillators als die Trägerfrequenz des Frequenzmodulationsverfahrens zu überprüfen und zu regeln. Eine derartige Regelung während des laufenden Betriebes ist dann möglich, wenn sich die Frequenzänderung der Grundfrequenz bzw. die Frequenzmodulation der Grundfrequenz durch das Nutzsignal über jenen Zeitraum statistisch hin wegmittelt, über welchen die Schwingungsperioden des Referenzsignals und die Schwingungsperioden des frequenzmodulierten Signals in der Vergleichseinheit 71 verglichen werden. Vorzugsweise weist das Nutzsignal hierbei Frequenzen eines Audiosignals auf, welche wiederum vorzugsweise im Bereich von 20Hz bis 20KHz liegen. Wird eine Grundfrequenz im Bereich von einigen MHz angestrebt, bei welcher beispielsweise lediglich eine zu erzielende Frequenzgenauigkeit der Trägerfrequenz +/-30KHz betragen soll, so ist eine Messfrequenz von 30Hz in der Vergleichseinheit für den Vergleich der Signale vollkommen ausreichend. Es wird somit vorzugsweise innerhalb eines solchen Messintervalls der Vergleich durchgeführt, innerhalb dessen die Grundfrequenz bzw. diese Trägerfrequenz ein deutliches Vielfaches an Schwingungsperioden aufweist. Vorzugsweise weist die Trägerfrequenz eine Frequenz auf, welche sich um mindestens drei Größenordnungen von der Messfrequenz unterscheidet. Hierdurch wird erzielt, dass geringfügige Fehler der Frequenzmessung sich nicht wesentlich auf das Vergleichsergebnis auswirken.

Vorzugsweise wird die Vorrichtung derart ausgestaltet, dass eine Änderung der Ansteuerung der Spannungsquelle 4 durch die Vergleichseinheit 71 durch unterschiedliche Schrittweiten von Änderungen erfolgt. Beispielsweise wird bei einem Systemstart einer Vorrichtung ein schnelles Einschwingen erwünscht, so dass eine höhere Schrittweite der Änderung der Regelung der gemeinsamen Spannungsquelle 4 durch die Vergleichseinheit 71 vorgesehen ist. Für den Fall, dass starke Temperaturänderungen vorliegen, welches durch Temperatursensoren vorzugsweise festgestellt werden kann, so ist es möglich, die Änderung des Spannungssignals der Spannungsquelle 4 mit einer hohen Schrittweite zu betreiben.

## Patentansprüche

1. Verfahren zur Regelung einer Grundfrequenz eines spannungsgesteuerten Oszillators (1) als eine Trägerfrequenz eines frequenzmodulierten Signals,
wobei zu einer Erzeugung des frequenzmodulierten Signals die Grundfrequenz des spannungsgesteuerten Oszillators (1) als die Trägerfrequenz in Abhängigkeit eines Nutzsignals moduliert wird,
wobei das Nutzsignal den spannungsgesteuerten Oszillator (1) über einen Schwingkreis (2) derart ansteuert, dass aufgrund einer Variation einer Kapazität einer ersten Kapazitätsdiode (11) des Schwingkreises (2) durch das Nutzsignal die Grundfrequenz mit dem Nutzsignal moduliert wird,
**dadurch gekennzeichnet, dass** die Grundfrequenz **dadurch** geregelt wird, dass die erste (11) und eine zweite (12) Kapazitätsdiode in dem Schwingkreis (2) durch ein Spannungssignal einer gemeinsamen Spannungsquelle (4) angesteuert werden.

2. Verfahren nach Anspruch 1,
**dadurch gekennzeichnet, dass** als Spannungssignal ein durch eine Tiefpaßschaltung (61) gefiltertes Puls-Weiten-Modulationssignal (65) verwendet wird.

3. Verfahren nach Anspruch 1,
**dadurch gekennzeichnet, dass** als Spannungssignal ein durch eine Digital-Analog-Wandlung gewonnenes Signal verwendet wird.

4. Verfahren nach einem der Ansprüche 1 bis 3,
**dadurch gekennzeichnet, dass** als erste (11) und zweite (12) Kapazitätsdiode unterschiedliche Kapazitätsoden verwendet werden.

5. Verfahren nach einem der Ansprüche 1 bis 4,
**dadurch gekennzeichnet, dass** die Ansteuerung der Kapazitätsdioden (11, 12) durch das Spannungssignal über unterschiedliche Widerstände (33, 27) erfolgt.

6. Verfahren nach einem der vorhergehenden Ansprüche,
**dadurch gekennzeichnet, dass** aus einem Vergleich des frequenzmodulierten Signals mit einem Referenzsignal eine Vergleichsgröße abgeleitet wird,
und dass in Abhängigkeit der Vergleichsgröße das Spannungssignal der gemeinsamen Spannungsquelle (4) zur Regelung der Grundfrequenz verändert wird.

7. Vorrichtung zur Regelung einer Grundfrequenz eines spannungsgesteuerten Oszillators (1) als eine Trägerfrequenz eines frequenzmodulierten Signals, umfassend einen Schwingkreis (2) mit einer ersten Kapazitätsdiode (1) zu einer Ansteuerung des spannungsgesteuerten Oszillators (1), wobei der Schwingkreis (1) einen Nutzsignaleinspeisungspunkt (3) zur Einspeisung eines Nutzsignals aufweist,
wobei durch Einspeisung des Nutzsignals an dem Nutzsignaleinspeisungspunkt (3) eine an der ersten Kapazitätsdiode (11) anliegende Spannung und somit eine Kapazität der ersten Kapazitätsdiode (11) derart variiert wird, dass das Grundfrequenzsignal mit dem Nutzsignal moduliert wird,
**dadurch gekennzeichnet, dass** durch eine Ansteuerung der ersten (11) und einer zweiten (12) Kapazitätsdiode des Schwingkreises (2) durch ein Spannungssignal einer gemeinsamen Spannungsquelle (4) eine Regelung der Grundfrequenz vorgenommen wird.

8. Vorrichtung nach Anspruch 7,
**gekennzeichnet durch**
eine Referenzeinheit (70) zur Bereitstellung eines Referenzsignals,
eine Vergleichseinheit (71) zur Ableitung einer Vergleichsgröße aus dem frequenzmodulierten Signal und dem Referenzsignal,
wobei die Vergleichseinheit (71) die gemeinsame Spannungsquelle (4) in Abhängigkeit der Vergleichsgröße derart ansteuert, dass **durch** eine Änderung des Spannungssignals der gemeinsamen Spannungsquelle (4) die Grundfrequenz geregelt wird.

9. Vorrichtung nach Anspruch 8,
**dadurch gekennzeichnet, dass** die gemeinsame Spannungsquelle (4) eine Generatoreinheit zur Erzeugung eines Puls-Weiten-Modulationssignals (65) und eine Tiefpassschaltung (61) umfasst.

10. Vorrichtung nach Anspruch 8,
**dadurch gekennzeichnet, dass** die gemeinsame Spannungsquelle (4) eine Wandlereinheit zur Wandlung eines Digital-Signals in das Spannungssignal umfasst.
